# FASCICULE DE BREVET EUROPEEN

(11) **EP 1 398 793 B1**
(45) Date de publication et mention de la délivrance du brevet: **21.05.2014**
(21) Numéro de dépôt: 03292185.0
(22) Date de dépôt: 05.09.2003
(51) Int. Cl.: G11C 11/412, G11C 11/419

(54) **Circuit intégré numérique réalisé en technologie MOS**
MOS technologische digital integrierte Schaltung
MOS technology fabricated digital integrated circuit

(30) Priorité: 06.09.2002 FR 0211060; 18.09.2002 FR 0211536
(43) Date de publication de la demande: 17.03.2004
(73) Titulaire: CSEM Centre Suisse d'Electronique et de Microtechnique S.A. - Recherche et Développement, 2007 Neuchâtel (CH)
(72) Inventeur: Cserveny, Stefan, 1066 Epalinges (CH); Masgonty, Jean-Marc, 2074 Marin (CH)
(74) Mandataire: Colas, Jean-Pierre

(56) Documents cités:
- US-A- 5 621 693
- US-A- 5 862 096
- US-A- 5 986 923
- US-A1- 2002 122 329
- US-B1- 6 172 901

## Description

La présente invention est relative à un circuit intégré numérique réalisé en technologie MOS, ayant au moins une partie de circuit pouvant être mise en veille par intermittence et dont l'état numérique en mode actif représente de l'information devant être conservée pendant le mode de veille.

Plus particulièrement, l'invention concerne de tels circuits dans lesquels la partie devant conserver son information d'état est une mémoire, destinée notamment à être utilisée avec un processeur avec lequel elle est de préférence intégrée sur une même puce semi-conductrice et qui constitue l'essentiel du reste du circuit intégré numérique.

Concernant en particulier les mémoires, on sait qu'elles pénalisent la vitesse de traitement des processeurs auxquels elles sont associées et elles absorbent la majeure partie de l'énergie nécessaire pour faire fonctionner l'ensemble. Avec la tendance à réduire de plus en plus la taille des transistors dans les circuits intégrés, la consommation statique des circuits devient, proportionnellement, de plus en plus importante, principalement en raison du fait que cette miniaturisation poussée réduit de plus en plus la tension de seuil des transistors composant le circuit intégré. Cela s'applique d'une façon générale aux circuits numériques évoqués en préambule et, plus particulièrement aux mémoires qu'elles soient de type RAM ou ROM.

Les demandes de brevet européen n° 00 401 972.5 et n° 01 401 984.8 au nom du Demandeur décrivent respectivement une mémoire vive statique (ci-après SRAM) et une mémoire morte (ci-après ROM) dans lesquelles les lignes de bits sont divisées en tronçons essentiellement dans le but de réduire les capacités associées à ces lignes de bits. Cependant, dans ces agencements antérieurs, les lignes de bit sont maintenues préchargées à la valeur de la tension d'alimentation, de sorte qu'il se produit un courant de fuite important en mode statique. Certes, dans une mémoire ROM, il est possible de couper les lignes de bits dans le mode statique et de ne précharger les lignes sélectionnées pour une lecture (mode actif ou dynamique) que très peu de temps avant la lecture proprement dite. Cependant, dans une mémoire SRAM, les cellules de mémoire, composées généralement de six transistors, doivent être alimentées en permanence avec une tension d'alimentation suffisante, sous peine de perdre l'information qui est stockée dans les cellules.

On sait par ailleurs que la polarisation du corps (terme désignant, selon le cas, le substrat ou le caisson dans lequel le transistor est formé) d'un transistor, par exemple négative pour un transistor NMOS, peut augmenter la tension de seuil de ce dernier et donc réduire en particulier la composante du courant de fuite la plus importante qui est le courant de coupure du transistor, lorsque le seuil est franchi vers le bas (fuite que l'on désignera ci-après par "fuite infraseuil", en anglais "subthreshold leakage"). La polarisation positive du même transistor NMOS entre sa source et le corps dans lequel il est placé, a le même effet et elle peut être utilisée aussi pour les transistors pour lesquels on ne prévoit pas de caissons séparés. Mais, cette solution présente l'inconvénient de réduire l'excursion de tension disponible et détériore la marge de bruit de la cellule de mémoire. En outre, une augmentation de la tension de seuil va de pair avec une réduction de la vitesse de fonctionnement, ce qui peut être gênant surtout lorsque le circuit est alimenté sous une faible tension d'alimentation.

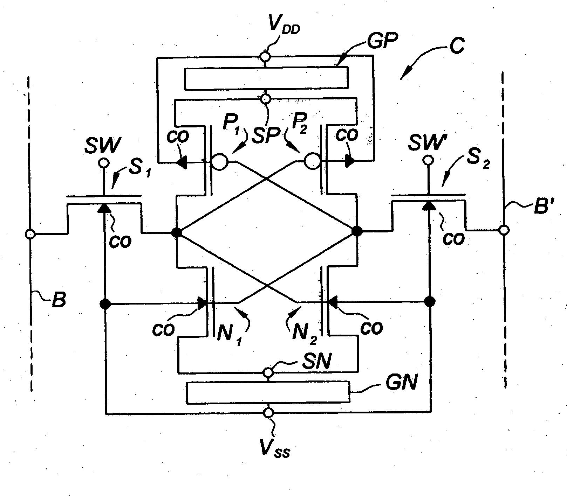

La figure 1 des dessins annexés représente, à titre d'exemple, une cellule de mémoire SRAM conforme au premier des documents antérieurs évoqués ci-dessus. Cette cellule, indiquée par la référence générale C, comprend essentiellement une bascule formée de deux inverseurs rebouclés, formés chacun de deux transistors en série de types p et n, respectivement P₁, N₁, P₂, N₂.

La cellule C comprend également des transistors de sélection S₁ et S₂ qui sont destinés à assurer la connexion de la cellule à des lignes de bits B et B' sous la commande de signaux SW et SW', respectivement.

En ce qui concerne cette cellule, il est déjà connu en soi, dans le but de pouvoir y appliquer une polarisation source/corps, de doter les sources des transistors de la bascule de la cellule C d'une connexion indépendante commune, respectivement SP et SN. A cet effet, les corps (indiqués par le sigle co) de ces mêmes transistors peuvent respectivement être connectés, pour ce qui concerne les transistors P₁ et P₂, à la tension d'alimentation V_{DD} et, pour ce qui concerne les transistors N₁ et N₂, à la tension d'alimentation V_{SS}, tandis qu'entre les bornes SP et V_{DD}, d'une part et SN et V_{SS} d'autre part sont prévus, ce qui est convenu d'appeler des moyens de connexion réalisés par exemple sous la forme de générateurs de polarisation GP et GN, de polarité négative et de polarité positive respectivement, indiqués ici simplement par un rectangle.

Dans la cellule C connue qui vient d'être décrite, on suppose que la polarisation est appliquée aussi bien aux transistors de type p qu'aux transistors de type n de la bascule de la cellule.

Cependant, dans les circuits intégrés à dimension de base très inférieure au micromètre, la nécessité de réduire la fuite infraseuil se fait surtout sentir au niveau des transistors NMOS à l'état bloqué. Or, dans ce genre de dispositifs semiconducteurs, la fuite infraseuil de ces transistors est bien supérieure à celle des transistors PMOS. Par conséquent, avec la tendance actuelle à miniaturiser toujours davantage les circuits intégrés, le problème de la fuite infraseuil des transistors NMOS en particulier est une préoccupation constante des spécialistes.

L'application d'une polarisation SP et/ou SN sur les sources correspondantes des transistors de types p et n réduit efficacement à une valeur acceptable la fuite infraseuil d'une cellule non sélectionnée de la mémoire (signaux SW ou SW' au niveau bas), pour autant que la tension d'alimentation restante présente une valeur suffisante pour maintenir l'état actuel de la cellule, tenu compte de la marge de bruit. Par contre, lorsque la cellule est sélectionnée et entre dans le mode actif de lecture et/ou d'écriture, il se produit une perte de vitesse de la mémoire, provoquée par la réduction du courant d'attaque alors disponible. On peut compenser partiellement cette perte de vitesse en adaptant la valeur de la tension de polarisation aux limites régissant le processus de fabrication, étant donné que la limite défavorable pour les fuites est favorable pour la vitesse et inversement. Cependant, cette méthode conduit à un compromis peu satisfaisant et ne permet pas d'utiliser une plage de tensions d'alimentation large compte tenu du fait que la relation entre fuite et vitesse de la mémoire est fortement dépendante de la tension d'alimentation.

De plus, le fait d'augmenter la tension de polarisation source/corps réduit la marge de bruit statique, ce qui est nuisible surtout en présence de faibles tensions d'alimentation. Le cas le plus défavorable pour la marge d'erreur se présente pendant la lecture, lorsque le transistor de sélection activé S₁ et/ou S₂ de la cellule dégrade la caractéristique de transfert d'inverseur.

Le principe de l'application d'une tension de polarisation telle qu'elle vient d'être décrite pour les mémoires SRAM peut être employé dans tout ou partie d'autres circuits numériques de type MOS afin de réduire les fuites infraseuil et donc de réduire autant que possible la consommation statique, tout en permettant de conserver l'information représentée par le circuit entier ou la partie du circuit en mode actif. Cependant, cette solution présente les inconvénients décrits ci-dessus et n'est donc pas satisfaisante.

Par le document US 5 621 693, on connaît un circuit du genre indiqué ci-dessus présentant les particularités du préambule de la revendication 1.

Dans ce cas, le potentiel du noeud commun réunissant les sources des transistors concernés des cellules situées dans une parties déterminée du circuit peut être commuté entre la masse et un potentiel qui est une fraction de la tension d'alimentation du circuit. Le potentiel de masse est alors maintenu sur le noeud commun pendant les périodes d'inactivité de la partie concernée du circuit. Ceci permet de réduire certes la consommation et de conserver utilement l'information en cas de non activité, mais ne peut apporter une solution à la réduction des courants de fuite pendant les phases d'inactivé de la partie concernée du circuit.

On connaît également du document US 6,172,901 B1, une cellule de mémoire, pouvant se mettre en veille pour réduire sa consommation. Dans le circuit divulgué, les sources des transistors NMOS des cellules mémoire dans chaque colonne sont reliées à deux bornes séparées ST et SC pour assurer le fonctionnement en écriture et en lecture. En état de veille, l'ensemble des colonnes du circuit entier est connecté à une partie de circuit spéciale pour réduire les fuites, et ainsi la consommation. De ce fait, l'entrée et la sortie de l'état de veille nécessitent la commutation d'une capacité énorme, résultant de l'ensemble des colonnes, ce qui réduit considérablement les possibilités d'optimisation de la consommation. En outre, le circuit divulgué dans ce document utilise des moyens de commutation des noeuds séparés ST et SC rajoutant ainsi des courants de fuite supplémentaires par rapport à une solution minimaliste.

L'invention a pour but de fournir un circuit intégré dans lequel, en vue de réduire la consommation statique et les courants de fuite, notamment d'infraseuil, on utilise le principe de l'augmentation de la tension de seuil par le biais de la méthode de polarisation source/corps, mais ce, sans que la vitesse de travail en mode actif du circuit soit sensiblement réduite, ni la marge de bruit détériorée et sans risque de perte d'information représentée par l'état de tout ou partie du circuit.

L'invention a donc pour objet un circuit présentant les caractéristiques de la revendication 1.

Ainsi, l'invention exploite le fait que le circuit ou la ou les parties concernées du circuit, ont par intermittence des périodes d'activité et des périodes de veille, ces périodes de veille correspondant à des intervalles de temps pendant lesquels l'information d'état présente en mode actif, tout en étant conservée, n'a pas besoin d'être utilisée. Par conséquent, grâce aux caractéristiques de l'invention, dans tout ou partie du circuit numérique, la polarisation des bornes de sources des transistors ou de la borne de source commune si ces sources sont réunies ensemble, peut être modifiée en fonction de l'état d'activité ou d'inactivité de tout ou partie du circuit dont l'état numérique représente une information, de sorte que les paramètres régissant chacun de ces états d'activité peuvent être rendus optimum. Ainsi, on peut obtenir une réduction plus importante des courants de fuite, notamment des courants de fuite infraseuil, que celle qu'il était possible de réaliser dans l'art antérieur tel qu'il vient d'être illustré à titre d'exemple à propos d'une cellule de mémoire SRAM.

Lorsque la partie de circuit concernée est une cellule de mémoire ou un groupe de cellules de mémoire, l'état de polarisation de la borne de source (dans le cas de cellules d'une mémoire ROM à un seul transistor) ou de la borne de source commune (dans la cas de cellules d'une mémoire RAM à plusieurs transistors), peut de même être modifié en fonction de l'état d'activité ou d'inactivité du groupe de cellules de mémoire ou de la cellule de mémoire considérée, ce qui permet d'obtenir les mêmes avantages que ceux décrits ci-dessus dans le cadre d'un circuit ou partie de circuit de type plus général.

L'invention peut également présenter les particularités intéressantes définies dans les sous-revendications.

D'autres caractéristiques et avantages de la présente invention apparaîtront au cours de la description qui va suivre, donnée uniquement à titre d'exemple et faite en se référant aux dessins annexés sur lesquels:
la figure 1, déjà décrite, montre un exemple de schéma d'une cellule de mémoire SRAM connue présentant des polarisations source/corps, positive pour les transistors NMOS et négative pour les transistors PMOS;
la figure 2A est un schéma très simplifié d'une partie de circuit, notamment d'une mémoire ROM dans laquelle sont incorporées quelques caractéristiques de l'invention;
la figure 2B est un schéma très simplifié d'une partie de circuit, notamment d'une mémoire RAM dans laquelle sont incorporées quelques caractéristiques de l'invention;
la figure 3 est un schéma plus détaillé de l'agencement de circuit selon la figure 2B;
la figure 4 montre, de façon simplifiée, le schéma d'une mémoire RAM intégrée présentant quelques caractéristiques de la présente invention ;
la figure 5 est un schéma de principe d'un mode de réalisation de l'invention intégrant un élément limiteur;
la figure 6A est une représentation de la caractéristique courant/tension idéale d'un élément limiteur selon l'invention ;
la figure 6B est un exemple de réalisation de l'élément limiteur selon l'invention à partir de composants idéaux ;
les figures 7, 8A à 8B et 9 à 11 sont des exemples de réalisation de l'élément limiteur selon l'invention à partir d'autres composants.
la figure 8C est un example de réalisation de l'élément limiteur selon l'invention à partir d'autres composants.

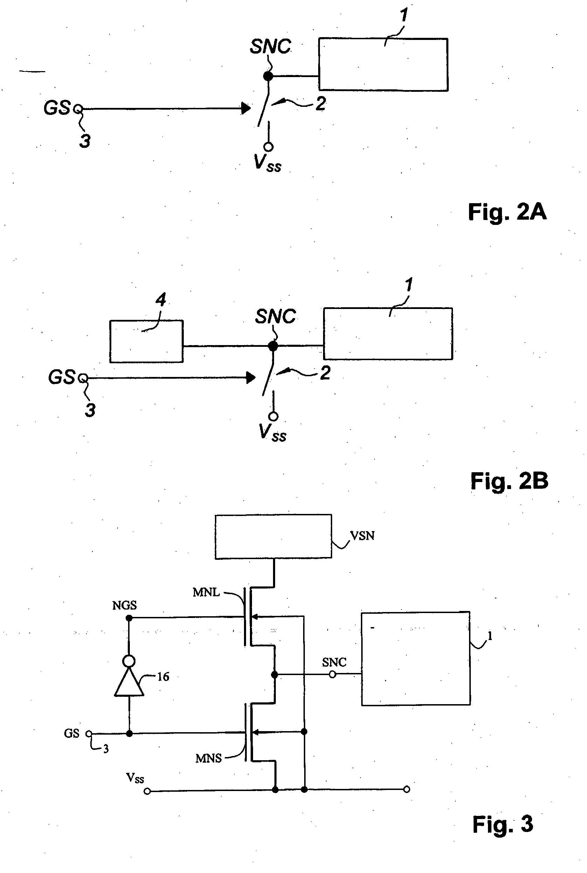

Avant d'aborder la description des figures 2 à 4, il y a lieu de noter qu'elle concerne l'application, à titre d'exemple, de l'invention au cas où une partie d'un circuit numérique de type MOS est formée par une mémoire intégrée. Dans ce cas, on suppose pour simplifier l'exposé, que la polarisation source/corps est appliquée uniquement aux transistors NMOS. Cependant, l'invention n'est pas limitée à cette application. Au contraire, elle peut être appliquée également, mutatis mutandis, à des circuits numériques dans lesquelles la polarisation source/corps concerne uniquement les transistors de type PMOS ou les deux types de transistors à la fois, comme cela a été suggéré dans la figure 1 déjà décrite.

Ceci étant, la description qui va suivre ne concerne, à titre d'exemple, que la polarisation négative source/corps des transistors NMOS dans le cadre d'une mémoire que celle-ci soit de type ROM ou RAM, étant entendu que les deux types de mémoires peuvent être dotés également de lignes de bits partagées telles que décrites dans les deux demandes de brevet européen déjà citées.

On rappellera que le terme "corps" utilisé dans le présent contexte, désigne soit un caisson dans lequel sont placés les transistors considérés de même type de conductivité, caisson lui-même incorporé dans le substrat du circuit intégré, soit le substrat lui-même, lorsque les transistors y sont directement incorporés sans caisson intermédiaire. C'est d'ailleurs cette dernière éventualité qui constitue l'une des possibilités d'application les plus intéressantes de l'invention.

La figure 2A est un schéma de principe d'une partie de mémoire ROM dans laquelle sont incorporées quelques caractéristiques de l'invention. Cette mémoire ROM est subdivisée en une pluralité de groupes de cellules, l'un de ces groupes étant représenté sous forme de bloc portant la référence 1. Comme connu en soi, une mémoire ROM comporte en général des cellules sans composant actif définissant un premier niveau logique et des cellules ayant un composant actif définissant l'autre niveau logique ; le composant étant, dans le cadre de l'invention, un transistor (ici non représenté) ayant une connexion de source. Dans le cadre de l'application plus générale de l'invention, on peut considérer que le bloc 1 est une partie d'un circuit numérique dont l'état représente une information que l'on souhaite conserver quel que soit l'état d'activité ou d'inactivité du groupe en question.

Selon représenté sur la figure 2A, les connexions de source des composants actifs des cellules du groupe de cellules 1, sont reliées ensemble pour former un noeud commun de sources SNC, les transistors des cellules étant supposés ici être de type n. Ce noeud commun de sources SNC est relié à des moyens de commutation 2 permettant de le brancher sélectivement à une source d'alimentation qui, dans le présent exemple, est une source de tension Vₛₛ. Les moyens de commutation 2 sont commandés par un signal de commande GS d'activation du groupe de cellules 1 pour ce qui concerne la polarisation source/corps des transistors, ce signal étant appliqué à une borne 3. Lorsque la mémoire ROM de la figure 2A se trouve en état de veille ou lorsqu'elle se trouve en mode actif, mais qu'un groupe de cellules considéré (par exemple le groupe 1) n'est pas sélectionné parce que le mot binaire recherché dans la mémoire ne se trouve pas dans ce groupe considéré, le signal GS commande les moyens de commutation 2 à l'ouverture et la tension V_{SS} n'est plus appliquée. Lorsque la mémoire travaille en mode actif et que des cellules dans lesquelles on veut lire sont présentes dans le groupe de cellules 1 considéré, l'organe de commutation 2 est fermé sous la commande du signal GS et le potentiel du noeud commun SNC est tiré vers le potentiel Vₛₛ (généralement la masse).

La figure 2B représente un schéma analogue à celui de la figure 2A et applicable plus particulièrement à une mémoire RAM ou SRAM. Le noeud commun de sources SNC est relié à un limiteur de tension 4. Le limiteur 4 a pour rôle d'éviter que le potentiel du noeud SNC ne dépasse la valeur acceptable pour respecter la marge de bruit imposée.

Lorsque la mémoire de la figure 2B se trouve en mode de veille ou lorsqu'elle se trouve en mode actif, mais qu'un groupe de cellules considéré (par exemple le groupe 1) n'est pas sélectionné parce que le mot binaire recherché dans la mémoire ne se trouve pas dans ce groupe considéré, le signal GS commande ici également les moyens de commutation 2 à l'ouverture. De la sorte, le potentiel du noeud SNC augmente, jusqu'à ce que la fuite de courant (qui diminue) dans les cellules du groupe considéré 1 vienne équilibrer le courant de fuite de l'organe de commutation 2. Le limiteur 4 a ici pour rôle d'éviter que le potentiel du noeud commun SNC ne dépasse alors la valeur acceptable pour respecter la marge de bruit imposée, mais dans ce cas en absorbant éventuellement la différence entre les deux courants de fuite.

Lorsque cette mémoire travaille en mode actif et que des cellules dans lesquelles on veut lire ou écrire sont présentes dans le groupe de cellules 1 considéré, les moyens de commutation 2 sont fermés sous la commande du signal GS et le potentiel du noeud commun SNC est tiré vers le potentiel V_{SS} (généralement la masse), comme dans le cas de la mémoire ROM. Cependant, dans ce cas, pour que le potentiel du noeud commun SNC soit suffisamment bas pendant l'opération de lecture/écriture pour maintenir la marge de bruit souhaitée, on fait apparaître, au cours de chaque cycle d'activité de la mémoire, le signal de commande GS activant les moyens de commutation 2, avant que n'apparaisse le signal de commande de lecture/écriture SW ou SW' qui active le mot recherché dans le groupe de cellules considéré.

Bien entendu, dans le cas des deux types de mémoire, la commutation du noeud commun de sources SNC par les moyens de commutation 2 implique une consommation d'énergie dynamique. Pour la maintenir à un niveau le plus faible possible, comparé à la consommation d'énergie dynamique à la lecture, le nombre de cellules dans un groupe doit être limité en prenant en compte l'excursion du potentiel du noeud commun SNC et la charge imposée par chaque cellule sur celui-ci, qui est plus importante que la charge imposée par la cellule à la ou aux ligne(s) de bits activée(s) pour la lecture et, le cas échéant, pour l'écriture. Cette exigence détermine le choix du nombre de cellules que l'on peut rassembler dans un groupe tel que le groupe 1.

On notera que le schéma de principe de la figure 2B peut s'appliquer également avantageusement à tout ou partie d'un circuit numérique de type MOS dont l'état représente une information que l'on souhaite conserver quel que soit l'état d'activité ou d'inactivité du groupe en question, alors que l'on souhaite en même temps respecter une valeur permettant de déterminer la marge de bruit imposée. Les bascules de types "latch" ou maître-esclave, les registres, les piles, etc. constituent des exemples de tels circuits numériques.

La figure 3 est un schéma plus détaillé permettant d'examiner un exemple préféré d'un principe d'implémentation des caractéristiques illustrées sur la figure 2B et, par conséquent, appliquées plus particulièrement à une mémoire RAM ou SRAM. On voit que les moyens de commutation 2 de la figure 2B sont formés ici par un transistor NMOS, MNS, dont la source est reliée à la tension d'alimentation V_{SS} et dont le drain est raccordé au noeud commun de sources SNC. La grille de ce transistor MNS est connectée à la borne 3 pour recevoir le signal d'activation de groupe GS. Le drain du transistor MNS est également connecté à la source d'un autre transistor NMOS, MNL, dont le drain est relié à une source de tension VSN. La grille du transistor MNL est connectée à la borne 3 par l'intermédiaire d'un inverseur 16 fournissant le signal NGS qui est le complément du signal GS. Par conséquent, lorsque le transistor MNS est rendu conducteur par le signal GS, le transistor MNL est bloqué et vice-versa. Le transistor MNL assure, avec la source VSN, la fonction de limitation et matérialise donc le limiteur 4 représenté sur la figure 2B. La source VSN fixe, dans cette implémentation, la valeur maximale du potentiel que peut prendre le noeud commun SNC.

Dans le mode actif, le transistor MNS est rendu conducteur par le signal GS, tandis que le transistor MNL est rendu non-conducteur. Dans l'état de veille, ou lorsque le groupe 1 de cellules ne contient pas le mot binaire recherché dans la mémoire, la situation est inverse. Lors de la conception du circuit, il convient de choisir soigneusement les paramètres du transistor MNS. En effet, le rapport de sa largeur W à sa longueur L doit être suffisant pour d'une part, préserver une vitesse de lecture appréciable et d'autre part, assurer un abaissement convenable du potentiel du noeud commun SNC vers le potentiel V_{SS} avant que le signal SW ou SW' de la figure 1 ne vienne sélectionner la cellule. Il est à noter qu'au cours de la lecture, le potentiel sur le noeud commun SNC dépend du courant de lecture provenant du groupe de cellules 1 lu et du rapport W/L du transistor MNS. Par ailleurs, le choix de ce rapport doit également tenir compte du fait que les fuites du transistor MNS doivent être réduites à une valeur suffisamment petite, cette valeur dépendant du nombre de cellules dans le groupe. En d'autres termes, les fuites du transistor MNS doivent être du même ordre de grandeur que les fuites des cellules du groupe. Le choix des dimensions du transistor MNL est moins critique.

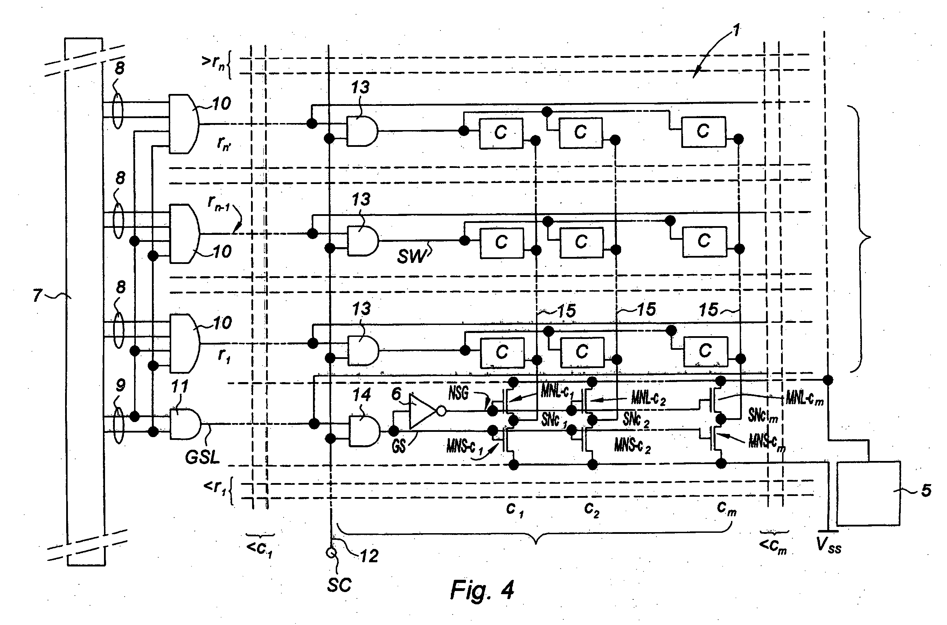

La figure 4 représente plus en détail le groupe 1 de cellules C d'une mémoire RAM ou SRAM et le circuit de polarisation source/corps associé à ce groupe de cellules 1. Le schéma représenté peut s'appliquer également, en faisant les modifications nécessaires apparaissant clairement aux spécialistes, à des mémoires ROM pour autant que l'on respecte le schéma de principe représenté sur la figure 2A.

Le groupe de cellules 1 de la figure 4 fait partie d'un réseau de mémoire conçu de la façon habituelle en rangées r et colonnes c, seules les rangées et les colonnes du groupe de cellules 1 étant représentées. Elles sont respectivement au nombre de n rangées, référencées r₁ à rₙ, et au nombre de m colonnes référencées c₁ à cₘ, les quantités de rangées et de colonnes dans chaque groupe tel que le groupe 1, étant déterminées en fonction des critères qui viennent d'être évoqués ci-dessus. Dans le réseau de mémoire, la rangée r₁ et la colonne c₁ sont respectivement précédées d'autres rangées et d'autres colonnes, ce qui pour simplifier le dessin est indiqué par <r₁ et <c₁ sur la figure 4. De même, à la rangée rₙ et à la colonne cₘ succèdent des rangées et des colonnes du réseau de mémoire, ce qui est désigné respectivement par >rₙ et >cₘ sur la figure 4, également pour simplifier la représentation. Dans les zones correspondant à ces rangées et colonnes de la mémoire, d'autres groupes de cellules sont constitués pour permettre d'y associer un dispositif de polarisation source/corps de la manière représentée pour le groupe de cellules 1.

La mémoire de la figure 4 comprend également un décodeur d'adresses de rangée 7 qui fournit, classiquement, les bits de sélection de rangée sur les lignes 8 et les bits d'activation de polarisation sur les lignes 9. Ces lignes 9 ne sont présentes qu'une fois pour chaque groupe de cellules. Les bits de sélection de rangées et les bits d'activation de polarisation apparaissant respectivement sur les lignes 8 et 9 sont combinés logiquement dans des portes ET 10. Les bits d'activation des lignes 9 sont combinés dans une porte ET 11.

Dans la configuration de mémoire décrite, qui n'est pas limitative dans le cadre de l'invention, un groupe de cellules représente un mot binaire par rangée (ici de la largeur de m cellules) et peut être activé par un signal SC d'activation de mot apparaissant sur une ligne verticale 12 du réseau de mémoire.

Le signal de sélection de mot SC est appliqué sur des portes ET 13 avec le signal de sélection de rangée issu des portes 10 pour activer, le cas échéant, toutes les cellules définissant un mot dans une rangée. Ce signal de sélection de mot SC est également combiné, dans une porte ET 14, avec le signal d'activation de polarisation GSL issu de la porte ET 11 appartenant au groupe de cellules 1 considéré dans le but de ne connecter au potentiel V_{SS} que les noeuds SNC des cellules correspondant au mot sélectionné par l'adressage et le signal de sélection de mot.

Le circuit de polarisation de cette mémoire est conçu comme celui représenté sur la figure 3, le bloc 5 de la figure 4 ayant la fonction de la source VSN de la figure 3. On voit que la mise en oeuvre de l'invention nécessite la présence, pour chaque colonne de cellules d'un groupe de cellules 1, d'une ligne de colonne supplémentaire 15 afin de pouvoir raccorder les noeuds SN de ces cellules les uns aux autres. Avantageusement, sur le circuit intégré de la mémoire, cette ligne de colonne supplémentaire est prévue entre les lignes de bit associées aux colonnes de cellules respectives, ce qui permet de réduire les interférences entre ces lignes de bits (pour la clarté de la figure 4, ces lignes de bits ne sont pas représentées).

Selon une variante non représentée aux dessins, il est également possible de ne prévoir, par groupe de cellules 1, qu'un seul ensemble des transistors MNS et MNL au lieu d'un ensemble de transistors par colonne. Dans ce cas, le rapport W/L de ces transistors doit être dimensionné pour l'ensemble des colonnes d'un groupe de cellules et les lignes de colonne 15 peuvent être remplacées par une seule ligne verticale associée à des connexions horizontales dans le groupe.

Selon une autre variante de réalisation, le groupe peut ne contenir qu'une seule rangée de cellules avec les sources SN reliées horizontalement au noeud commun SNC. Cette variante devient très intéressante si le groupe a la dimension d'une rangée entière car cela supprime la nécessité d'un moyen particulier 11 de sélection de groupe; la sélection normale de la rangée par le moyen 10 remplissant cette tâche. Cette variante permet aussi d'utiliser des tensions plus élevées que V_{DD} ou plus faibles que V_{SS}, ce qui facilite la réalisation du transistor MNS.

Selon encore une autre variante non représentée, le signal d'activation d'un groupe GS est activé dès qu'un mot appartenant à ce groupe est sélectionné, soit lorsque le signal GSL est lui-même sélectionné, et ce, indépendamment de l'état actif ou non de la mémoire. Dans ce cas, le noeud SNC ne subira pas de modification tant que les mots successivement sélectionnés appartiennent au même groupe. La consommation dynamique est donc réduite pour le groupe puisque le noeud SNC n'est, dans un tel cas, pas commuté. Par contre, la consommation statique d'un tel groupe dans une mémoire au repos s'en trouve dès lors augmentée. Là encore, on notera l'importance de la répartition de la mémoire en groupes suffisants.

D'après la description qui précède, on constate que le fait de pouvoir commuter la polarisation source/corps sélectivement en fonction de l'état d'activité des cellules, que ce soit celles d'une mémoire ROM ou celles d'une mémoire RAM ou SRAM, permet de limiter la consommation d'énergie des moyens de polarisation aux seuls transistors de ces moyens qui agissent sur le groupe de cellules contenant des cellules actives à un moment considéré. Il en résulte que la présence de ces moyens de polarisation n'augmente que très faiblement la consommation dynamique de la mémoire. Par ailleurs, la grande majorité des cellules non actives pendant un cycle d'activité de la mémoire sont maintenues également dans leur mode de faible fuite, ce qui contribue également à la réduction de consommation.

Cependant, d'autres solutions sont envisageables pour réaliser la fonction de limitation remplie dans le cas de la figure 3 par le transistor MNL et la source de tension VSN. En effet l'interrupteur sur l'alimentation matérialisé par le transistor MNS par exemple ou une polarisation entre source et substrat qui augmente la tension de seuil des transistors permettent de limiter la consommation d'un circuit quand il est inactif. Mais si tout ou partie du circuit ne doit pas perdre l'information de son état même quand il n'est pas actif, un interrupteur sur l'alimentation à lui seul risque d'être insuffisant pour garantir le maintien de l'état du circuit du fait que la valeur de la tension d'alimentation est "flottante". D'autre part, on a vu également qu'une polarisation source/substrat permanente prévue dans l'art antérieur pénalise la vitesse et la marge de bruit.

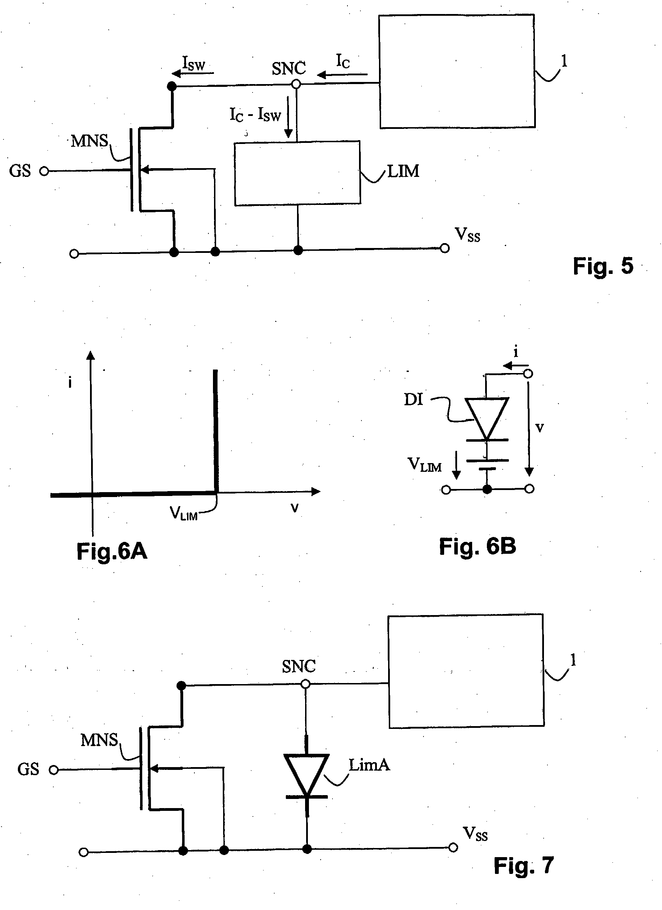

Selon l'invention, la fonction de limitation peut ainsi être remplie autrement qu'en imposant une valeur de tension sur le noeud commun SNC. Le principe de réalisation en est donné par la figure 5.

Dans le cadre d'application générale de l'invention, on considère un bloc 1 correspondant à une partie ou à l'ensemble d'un circuit numérique qu'on veut placer en état de veille pour réduire sa consommation statique tout en préservant dans le mode de veille l'information d'état présente en mode actif. Tout ou partie du circuit numérique considéré peut ainsi être divisé en de tels blocs 1, chacun des blocs pouvant être activé indépendamment des autres blocs et désactivé individuellement. Typiquement un bloc n'est activé que lorsqu'il faut activer au moins l'un des éléments qui entrent dans sa composition, indépendamment de l'activité du reste du circuit et des autres blocs. On rappelle que dans le cas particulier d'une mémoire, le bloc 1 peut correspondre à un ou des groupes de cellules de mémoire, comme cela a été décrit à propos des figures 2 ou 3.

Pour chaque bloc 1, la variation de polarisation sur le noeud SNC est commandée par des moyens de commutation, typiquement par un interrupteur analogue au transistor MNS décrit précédemment. Sur la figure 5, on retrouve ce transistor MNS, ainsi qu'un bloc limiteur LIM, connecté en parallèle avec le transistor MNS, entre le noeud commun SNC et la borne d'alimentation V_{SS}.

Comme précédemment, le signal de commande GS rend le transistor MNS conducteur quand le bloc 1 est en mode actif, en tirant le noeud commun SNC vers le potentiel V_{SS}. Pour que le noeud SNC soit suffisamment proche du potentiel V_{SS}, le transistor MNS doit conduire fortement par rapport au courant délivré par le circuit actif.

Lorsque le bloc 1 est en mode de veille, la commande GS maintient le transistor MNS non conducteur, de sorte que le potentiel du noeud commun SNC augmente. Ceci diminue fortement le courant de fuite du bloc 1 et augmente légèrement le courant de fuite du transistor MNS alors bloqué.

En absence du limiteur LIM, le potentiel du noeud SNC s'établit à l'équilibre du courant de fuite lc du bloc 1 et celui lsw du transistor MNS. Pour un bloc 1 qui a besoin d'une certaine tension de polarisation pour maintenir son état jusqu'au moment où il sera de nouveau activé, il y a une limite supérieure pour le potentiel du noeud SNC à ne pas dépasser. Le rôle du limiteur LIM est à la fois de maintenir une polarisation sur le noeud commun SNC et d'absorber la différence Ic-Isw entre le courant de fuite Ic du bloc 1 et celui Isw, plus petit, du transistor MNS pour établir un équilibre entre ces trois courants avec une valeur acceptable du potentiel du noeud SNC. Il est à noter que lorsque le bloc 1 est en mode actif et que le transistor MNS est conducteur, le limiteur LIM n'est pas gênant car son courant - du fait que la chute de tension à ses bornes est quasi nulle - est négligeable par rapport aux forts courants du bloc 1 et du transistor MNS.

La caractéristique courant/tension du limiteur tel que décrit est idéalement celle représentée sur le diagramme de la figure 6A. Dans un tel limiteur, que l'on peut qualifier de dipôle unidirectionnel idéal, le courant aux bornes du limiteur est nul si la tension V est inférieure à une tension de seuil V_{LIM} et le courant devient non nul pour une tension égale à cette tension de seuil V_{LIM}. Comme représenté sur la figure 6B, ce limiteur peut être matérialisé par un dipôle constitué par l'association en série d'une diode idéale Dl avec une source de tension idéale V_{LIM} et dont la caractéristique courant/tension est celle de la figure 6A.

Selon une autre caractéristique de l'invention, on peut utiliser pour la réalisation du limiteur LIM tout composant dont la caractéristique courant/tension est proche de celle de la figure 6A. On peut y parvenir en utilisant toute diode ou tout dipôle réalisable dans la même technologie que celle du circuit concerné, même si sa caractéristique courant/tension réelle est assez éloignée de cette caractéristique idéale, à condition toutefois qu'on satisfasse simultanément les spécifications sur la consommation statique et la marge de bruit pour le maintien de l'état dans les pires cas des paramètres technologiques et des conditions de travail en température et en tension d'alimentation.

Le composant peut être une diode connectée entre le noeud commun SNC et le potentiel V_{SS}, passante du noeud SNC vers le substrat du circuit numérique relié au potentiel V_{SS}, une diode Zener LimA (figure 7) étant dans ce cas un mode de réalisation.

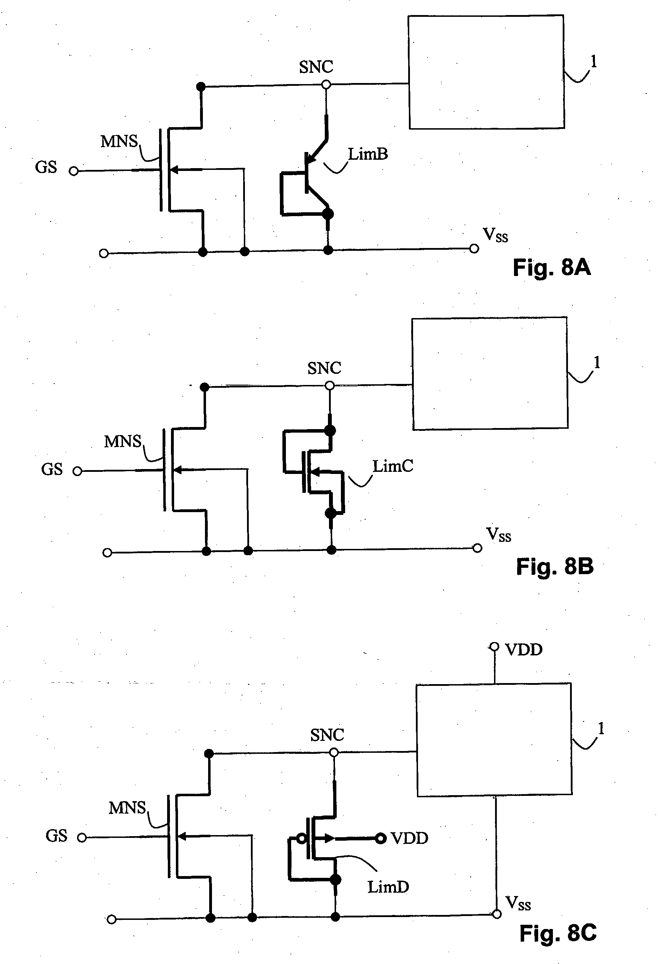

On peut également réaliser la fonction de limiteur en utilisant un transistor monté en diode: un transistor bipolaire PNP LimB (figure 8A), un transistor NMOS LimC (figure 8B), ou un transistor PMOS LimD (figure 8C). Ces différent composants ont, lorsque le courant direct est plus grand que les fuites de leurs jonctions, des caractéristiques courant/tension essentiellement exponentielles, avec un courant proportionnel à exp(V/n/U_{T}) où V est la chute de tension, U_{T} la tension thermique k*T/q et n un facteur de non idéalité.

Dans chacun des cas on voit que la grille du transistor est connectée à l'une de ses autres bornes et que, dans le cas du transistor MOS, sa source est reliée au substrat (le cas échéant, au caisson).

Avantageusement, si le limiteur LIM comporte de tels composants passifs (ces composants restent passifs dans leur fonctionnalité même s'ils sont réalisés à l'aide de transistors), il est possible d'utiliser un tel limiteur pour chaque bloc 1 du circuit numérique, car il ne nécessite aucune commande ou source de tension.

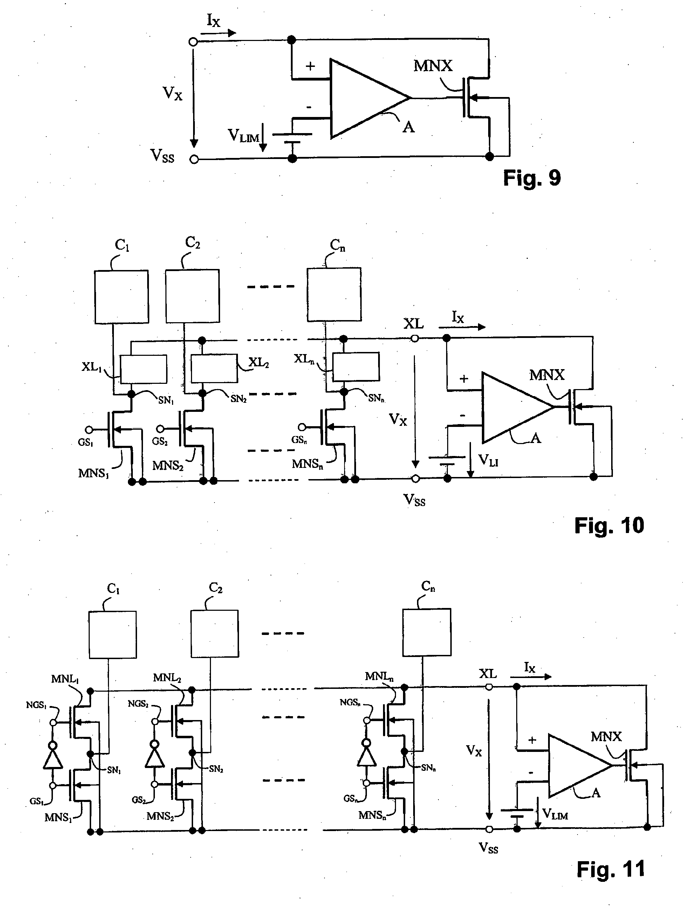

Cependant, selon un autre mode de réalisation du limiteur, on utilisera des éléments actifs avec gain, tel qu'un amplificateur/comparateur. Un tel limiteur est représenté sur la figure 9. Il comporte un amplificateur/comparateur A dont l'entrée inverseuse est reliée à une source de tension de référence délivrant la tension V_{LIM}. Cette source de tension étant reliée par ailleurs au potentiel V_{SS}. L'amplificateur/comparateur commande un transistor NMOS MNX dont le trajet drain source est connecté entre l'entrée non inverseuse de l'amplificateur/comparateur et le substrat (au potentiel V_{SS}) et qui fait office de source de courant.

Lorsque la tension Vx à l'entrée du dipôle de la figure 9 est inférieure à la tension V_{LIM}, la tension en sortie du comparateur, et donc sur la grille du transistor MNX est nulle. Le transistor MNX est alors bloqué. Lorsque la tension Vx dépasse très légèrement la valeur V_{LIM}, la tension sur la grille du transistor MNX augmente, le transistor MNX devient passant et absorbe l'excès de courant lx (soit, l_{c} - l_{sw} de la figure 5). Ce mode de réalisation permet donc d'obtenir une caractéristique courant/tension du limiteur qui est très proche de la caractéristique idéale donnée sur la figure 6A.

Contrairement à la solution avec des circuits connectés à une source de tension fixe, l'agencement de la figure 9 reste un ensemble passif dans sa fonctionnalité - bien qu'il ne le soit pas du fait de sa construction et de sa consommation - n'absorbant que le courant nécessaire de l'ensemble des blocs de circuit auquel il a été attribué.

Avantageusement du point de vue de la consommation, on utilise un tel limiteur pour plusieurs parties de circuit tels que les blocs C1, C2, à Cn de la figure 10. Dans ce cas, le limiteur est connecté de manière à pouvoir être relié sélectivement à chaque bloc de circuit par l'intermédiaire d'un élément de commutation XL1, XL2, ..., XLn qui lui est respectivement associé. Le rôle d'un tel élément de commutation est de relier le noeud commun de chaque bloc SN1, SN2, ..., SNn au limiteur lorsque le bloc correspondant C1, C2, ..., Cn est en mode de veille, et de l'en séparer lorsque ce bloc est en mode actif et que son noeud commun SNC est tiré vers le potentiel V_{SS}.

Un tel élément de commutation peut être réalisé, soit à partir d'une diode idéale, soit à partir d'une résistance de rappel vers le niveau haut (« pull-up » en anglais), soit encore avec un transistor MNL, selon le principe déjà décrit et représenté sur la figure 3. Dans ce cas, selon le schéma donné à la figure 11, le transistor MNL1, MNL2, ..., MNLn associé à un bloc C1, C2, ..., Cn donné est commandé par le signal NGS1, NGS2, ..., NGSn complémentaire au signal GS1, GS2, ..., GSn de commande du transistor MNS1, MNS2, ..., MNSn réalisant l'interrupteur 2 pour le bloc C1, C2, ..., Cn correspondant. Contrairement à la solution de la figure 3 où la source de tension VSN impose sa tension en délivrant ou absorbant les excès de courant, c'est le limiteur comprenant l'amplificateur/comparateur qui va absorber les excès de courant lorsque la tension limite est atteinte. Lorsque la tension limite n'est pas atteinte, les courants de fuite se redistribuent entre les blocs. Même si dans le cas des figures 9, 10 et 11 le limiteur comporte une source de tension V_{LIM}, cette source de délivre aucun courant.

## Revendications

1. Circuit intégré numérique réalisé en technologie MOS, comprenant une pluralité de cellules (C) réparties en une pluralité de parties (1) de circuit pouvant sélectivement être mis en veille par intermittence et dont l'état numérique en mode actif représente de l'information devant être conservée en mode de veille,
chaque cellule (C) de chacune desdites parties (1) de circuit comportant des transistors de types de conductivité opposés (P₁, P₂, N₁, N₂), les connexions de source (SN, SP) des transistors de même type de conductivité dans chaque cellule étant reliées ensemble, par l'intermédiaire de moyens de connexion, à une borne d'alimentation (V_{DD}, V_{SS}) ayant la polarité correspondant au type de conductivité des transistors associés, les connexions de source de tous les transistors d'au moins l'une desdits types de conductivité dans une même partie de circuit (1) étant reliées ensemble à un noeud (SNC) commun de sources et lesdits moyens de connexion comprenant des moyens de commutation (2) permettant de modifier l'état de polarisation du noeud (SNC) commun de sources en fonction de l'état d'activité de ladite partie (1) de circuit ou de sa sélection,
ledit circuit intégré comprenant également des moyens de commande (3, GS) délivrant un signal de commande (GS) pour commander l'état de polarisation dudit noeud commun (SNC) en fonction de l'état d'activité ou de veille de ladite partie de circuit,
lesdits moyens de commutation (2) sont agencés de manière à connecter, sous la commande desdits moyens de commande, ledit noeud (SNC) commun de sources à la borne d'alimentation (Y_{DD}, V_{SS}) propre au type de conductivité des transistors raccordés à ce noeud, lorsque ladite partie (1) de circuit est en mode actif et à déconnecter ledit noeud (SNC) commun de sources de cette borne d'alimentation (V_{DD}, V_{SS}), lorsque ladite partie (1) de circuit est en mode de veille,
**caractérisé en ce que** ledit noeud (SNC) commun de sources est connecté directement à un limiteur (4) pour limiter la tension sur ledit noeud (SNC) commun de sources lorsque ladite partie (1) de circuit est en mode de veille,
**en ce que** ledit limiteur comprend un dipôle unidirectionnel (LimD) qui est non conducteur lorsque ladite partie (1) de circuit est en mode actif et conducteur lorsque ladite partie (1) de circuit est en mode de veille, et
**en ce que** ledit limiteur (4) comporte un transistor PMOS (LimD) monté en diode et dont le trajet source-drain est connecté entre ledit noeud (SNC) commun de sources et ladite borne d'alimentation V_{SS}.

2. Circuit selon la revendication 1, **caractérisé en ce que** lesdits moyens de commutation (2) sont formés par un transistor (MNS) dont le trajet source-drain est connecté entre ladite borne d'alimentation (V_{SS}) et ledit noeud (SNC) commun de sources, et **en ce que** la grille dudit transistor (MNS) est connectée de manière à être commandée par un signal (GS) représentatif de l'état d'activité de ladite partie (1) de circuit ou de sa sélection.

3. Circuit selon la revendication 2, **caractérisé en ce que** le rapport de la largeur par la longueur dudit transistor (MNS) des moyens de commutation (2) est choisi en fonction de la vitesse de lecture de l'information contenue dans lesdites cellules (C) et de l'abaissement du potentiel dudit noeud commun (SNC) vers ledit potentiel de ladite borne d'alimentation (V_{SS}), préalablement à la sélection de ces cellules (SW ou SW') le choix de ce rapport tenant étant fait de telle manière que les fuites dudit transistor (MNS) soient réduites à une valeur dépendant du nombre de cellules dans ladite partie (1), et le nombre de cellules dans ladite partie (1) étant limité en prenant en compte l'excursion du potentiel dudit noeud commun (SNC) et la charge imposée par chaque cellule sur celui-ci.

4. Circuit selon l'une quelconque des revendications 1 à 3, **caractérisé en ce que** ledit limiteur (4) est commun à plusieurs parties (C₁, C₂, ....Cₙ) de circuit et **en ce qu'**il est prévu pour chacune desdites parties de circuit un élément de commutation (XL₁, XL₂,... XLₙ) propre à chaque partie de circuit et monté de manière à pouvoir connecter le limiteur au noeud (SN₁, SN₂,... SNₙ) commun de source associé à ladite partie de circuit en fonction de l'état d'activité de ladite partie de circuit.

5. Circuit selon l'une quelconque des revendications 1 à 4, **caractérisé en ce que** ledit circuit comprend une mémoire ROM, RAM ou SRAM et que ladite ou lesdites parties (1) de circuit est/sont une cellule ou un ou des groupes (1) de cellules de ladite mémoire.

6. Circuit selon la revendication 5, **caractérisé en ce qu'**un groupe (1) de cellules s'étend sur au moins une partie (r₁ à rₙ) des rangées d'une pluralité de rangées (<r₁, r₁ à rₙ, >rₙ) du réseau de ladite mémoire et au moins une partie (c₁ à cₘ) des colonnes d'une pluralité de colonnes (<c₁, c₁ à cₘ, >cₘ) du réseau de ladite mémoire.

7. Circuit selon la revendication 6, **caractérisé en ce qu'**un groupe (1) de cellules s'étend sur une rangée entière du réseau de ladite mémoire.

8. Circuit selon l'une quelconque des revendications 6 et 7, **caractérisé en ce que** lesdits moyens de commutation (MNS-c₁ à MNS-cₘ) sont prévus par partie de colonnes (c₁ à cₘ) dudit groupe (1) de cellules et **en ce que** lesdits moyens de commande (GSL, SC, 14) sont communs à l'ensemble dudit groupe (1) de cellules en commandant collectivement lesdits moyens de commutation (MNS-c₁ à MNS-cₘ).

9. Circuit selon l'une quelconque des revendications 6 à 8, **caractérisé en ce que** ledit signal de commande (GS) est engendré à partir d'un bit de l'adresse de rangée appliquée à ladite mémoire.

10. Circuit selon l'une quelconque des revendications 5 à 9, **caractérisé en ce que** dans le mode actif du groupe (1) de cellules, ledit signal de commande (GS) est engendré avant que n'apparaisse le signal de commande correspondant à ce mode actif de lecture et/ou d'écriture (SW, SW') sur les cellules du groupe (1) de cellules.

## Patentansprüche

1. Digitale integrierte Schaltung, die in MOS-Technologie ausgeführt ist, eine Vielzahl von Zellen (C) umfassend, die in einer Vielzahl von Schaltungsabschnitten (1) verteilt sind, die zeitweilig selektiv in Bereitschaft versetzt werden können, und deren digitaler Zustand im aktiven Modus Information darstellt, die im Bereitschaftsmodus beibehalten werden soll,
wobei jede Zelle (C) jedes der Schaltungsabschnitte (1) Transistoren entgegengesetzter Leitfähigkeitstypen (P₁, P₂, N₁, N₂) umfasst, wobei die Source-Anschlüsse (SN, SP) der Transistoren desselben Leitfähigkeitstyps in jeder Zelle zusammen mittels Anschlusseinrichtungen an einen Versorgungsanschluss (V_{DD}, Vss) angeschlossen sind, der die dem Leitfähigkeitstyp der zugeordneten Transistoren entsprechende Polarität hat, wobei die Source-Anschlüsse aller Transistoren mindestens eines der Leitfähigkeitstypen in einem gleichen Schaltungsabschnitt (1) zusammen an einen gemeinsamen Knoten (SNC) von Sources angeschlossen sind, und die Anschlusseinrichtungen Schalteinrichtungen (2) umfassen, die es ermöglichen, den Polarisationszustand des gemeinsamen Knotens (SNC) der Sources in Abhängigkeit vom Aktivitätszustand des Schaltungsabschnitts (1) oder seiner Auswahl zu verändern,
wobei die integrierte Schaltung auch Steuereinrichtungen (3, GS) umfasst, die ein Steuersignal (GS) abgeben, um den Polarisationszustand des gemeinsamen Knotens (SNC) in Abhängigkeit vom Aktivitäts- oder Bereitschaftsmodus des Schaltungsabschnitts zu steuern,
wobei die Schalteinrichtungen (2) dazu eingerichtet sind, unter der Steuerung der Steuereinrichtungen, den gemeinsamen Knoten (SNC) der Sources auf den Versorgungsanschluss (V_{DD}, V_{SS}) mit dem Leitfähigkeitstyp, der den an diesen Knoten angeschlossenen Transistoren eigen ist, aufzuschalten, wenn sich der Schaltungsabschnitt (1) im aktiven Modus befindet, und den gemeinsamen Knoten (SNC) der Sources von diesem Versorgungsanschluss (V_{DD}, V_{SS}) abzutrennen, wenn sich der Schaltungsabschnitt (1) im Bereitschaftsmodus befindet,
**dadurch gekennzeichnet, dass** der gemeinsame Knoten (SNC) der Sources direkt auf einen Begrenzer (4) zum Begrenzen der Spannung des gemeinsame Knotens (SNC) der Sources aufgeschaltet ist, wenn sich der Schaltungsabschnitt (1) im Bereitschaftsmodus befindet,
dass der Begrenzer einen unidirektionalen Dipol (LimD) umfasst, der nicht leitend ist, wenn sich der Schaltungsabschnitt (1) im aktiven Modus befindet, und leitend ist, wenn sich der Schaltungsabschnitt (1) im Bereitschaftsmodus befindet, und
dass der Begrenzer (4) einen PMOS-Transistor (LimD) umfasst, der als Diode angebracht ist, und dessen Source-Drain-Pfad zwischen dem gemeinsamen Knoten (SNC) der Sources und dem Versorgungsanschluss V_{SS} zwischengeschaltet ist.

2. Schaltung nach Anspruch 1, **dadurch gekennzeichnet, dass** die Schalteinrichtungen (2) durch einen Transistor (MNS) gebildet sind, dessen Source-Drain-Pfad zwischen dem Versorgungsanschluss (V_{SS}) und dem gemeinsamen Knoten (SNC) der Sources zwischengeschaltet ist, und dass das Gate des Transistors (MNS) so angeschlossen ist, dass es durch ein Signal (GS) gesteuert wird, das für den Aktivitätszustand des Schaltungsteils (1) oder seine Auswahl repräsentativ ist.

3. Schaltung nach Anspruch 2, **dadurch gekennzeichnet, dass** das Verhältnis Breite durch Länge des Transistors (MNS) der Schalteinrichtungen (2) in Abhängigkeit von der Auslesegeschwindigkeit der in den Zellen (C) enthaltenen Information und der Absenkung des Potentials des gemeinsamen Knotens (SNC) zum Potential des Versorgungsanschlusses (V_{SS}) ausgewählt ist, wobei vor der Auswahl dieser Zellen (SW oder SW') die Auswahl dieses bestehenden Verhältnisses so erfolgt, dass die Verluste des Transistors (MNS) auf einen Wert reduziert werden, der von der Anzahl der Zellen in diesem Abschnitt (1) abhängt, und wobei die Anzahl der Zellen in dem Abschnitt (1) begrenzt wird, indem die Drift des Potentials des gemeinsamen Knotens (SNC) und die durch jede Zelle an diesen angelegte Last berücksichtigt wird.

4. Schaltung nach einem der Ansprüche 1 bis 3, **dadurch gekennzeichnet, dass** der Begrenzer (4) mehreren Schaltungsabschnitten (C₁, C₂,... Cₙ) gemeinsam ist, und dass für jeden dieser Schaltungsabschnitte ein Schaltelement (XL₁, XL₂, ...XLₙ) vorgesehen ist, das jedem Schaltungsabschnitt zueigen und so angebracht ist, dass es den Begrenzer an den dem Schaltungsabschnitt zugeordneten gemeinsame Knoten (SN₁, SN₁, ..., SNₙ) der Sources in Abhängigkeit vom Aktivitätszustand des Schaltungsabschnitts aufschalten kann.

5. Schaltung nach einem der Ansprüche 1 bis 4, **dadurch gekennzeichnet, dass** die Schaltung einen ROM-, RAM oder SRAM-Speicher umfasst, und dass der oder die Schaltungsabschnitt/e (1) eine Zelle oder eine Gruppe oder Gruppen (1) von Zellen des Speichers ist/sind.

6. Schaltung nach Anspruch 5, **dadurch gekennzeichnet, dass** eine Gruppe (1) von Zellen sich über zumindest einen Teil (r₁ bis rₙ) der Reihen einer Vielzahl von Reihen (<r₁, r₁ bis rₙ, >rₙ) des Netzes des Speichers und zumindest einen Teil (c₁ bis cₘ) der Spalten einer Vielzahl von Spalten (<c₁, c₁ bis cₘ, >cₘ) des Netzes des Speichers erstreckt.

7. Schaltung nach Anspruch 6 **dadurch gekennzeichnet, dass** sich eine Gruppe (1) von Zellen über eine ganze Reihe des Netzes des Speichers erstreckt.

8. Schaltung nach einem der Ansprüche 6 und 7, **dadurch gekennzeichnet, dass** die Schalteinrichtungen (MNS-c₁ bis MNS-cₘ) pro Abschnitt von Spalten (c₁ bis cₘ) der Gruppe (1) von Zellen vorgesehen sind, und dass die Steuereinrichtungen (GSL, SC, 14) der Gesamtheit der Gruppe (1) von Zellen gemeinsam sind, indem sie kollektiv die Schalteinrichtungen (MNS-c₁ bis MNS-cₘ) steuern.

9. Schaltung nach einem der Ansprüche 6 bis 8, **dadurch gekennzeichnet, dass** das Steuersignal (GS) aus einem Bit der dem Speicher zugeteilten Reihenadresse generiert wird.

10. Schaltung nach einem der Ansprüche 5 bis 9, **dadurch gekennzeichnet, dass** im aktiven Modus der Gruppe (1) von Zellen das Steuersignal (GS) generiert wird, bevor das Steuersignal, das diesem aktiven Lese- und/oder Schreibmodus (SW, SW') entspricht, an den Zellen der Gruppe (1) von Zellen aufläuft.

## Claims

1. Digital integrated circuit designed using MOS technology comprising a plurality of cells (C) distributed over a plurality of circuit parts (1) that can intermittently be put selectively into standby mode and their digital status in active mode represents information that must be stored in standby mode,
each cell (C) of each of said circuit parts (1) comprising opposed conductivity transistors (P₁, P₂, N₁, N₂), wherein the source connections (SN, SP) of transistors of the same type of conductivity in each cell are connected together by means of connection devices to a supply terminal (V_{DD}, V_{SS}) having the polarity corresponding to the type of conductivity of the associated transistors, the source connections of all the transistors of at least one of said types of conductivity in the same circuit part (1) are connected together at a common source node (SNC) and said connection devices comprise switching devices (2), which enable the polarisation status of the common source node (SNC) to be modified as a function of the activity status of said circuit part (1) or of its selection,
wherein said integrated circuit also comprises control devices (3, GS), which supply a control signal (GS) to control the polarisation status of said common node (SNC) as a function of the activity status or standby status of said circuit part,
wherein said switching devices (2) are arranged in order to connect, under the control of said control devices, said common source node (SNC) to the supply terminal (V_{DD}, V_{SS}) specific to the type of conductivity of the transistors connected to this node when said circuit part (1) is in active mode and to disconnect said common source node (SNC) of this supply terminal (V_{DD}, V_{SS}) when said circuit part (1) is in standby mode,
**characterised in that** said common source node (SNC) is directly connected to a limiter (4) to limit the voltage on said common source node (SNC) when said circuit part (1) is in standby mode,
**in that** said limiter comprises a unidirectional dipole (LimD), which is non-conductive when said circuit part (1) is in active mode and conductive when said circuit part (1) is in standby mode, and
**in that** said limiter (4) comprises a diode-mounted pMOS transistor (LimD), the source-drain path of which is connected between said common source node (SNC) and said supply terminal Vss.

2. Circuit according to claim 1, **characterised in that** said switching devices (2) are formed by a transistor (MNS), the source-drain path of which is connected between said supply terminal (V_{SS}) and said common source node (SNC), and that the gate of said transistor (MNS) is connected so as to be controlled by a signal (GS) representing the activity status of said circuit part (1) or of its selection.

3. Circuit according to claim 2, **characterised in that** the ratio of the width to the length of said transistor (MNS) of the switching devices (2) is chosen as a function of the information reading speed contained in said cells (C) and the decrease of the potential of said common node (SNC) to said potential of said supply terminal (V_{SS}), wherein prior to the selection of these cells (SW or SW') the choice of this applicable ratio is made so that the leakages of said transistor (MNS) are reduced to a value dependent on the number of cells in said part (1), and the number of cells in said part (1) is limited taking into account the drift of the potential of said common node (SNC) and the load placed by each cell thereon.

4. Circuit according to any one of claims 1 to 3, **characterised in that** said limiter (4) is common to several circuit parts (C₁, C₂, ... Cₙ) and that for each of said circuit parts a switching element (XL₁, XL₂, ... XLₙ) specific to each circuit part is provided and mounted to be able to connect the limiter to the common source node (SN₁, SN₂, ... SNₙ) associated with said circuit part as a function of the activity status of said circuit part.

5. Circuit according to any one of claims 1 to 4, **characterised in that** said circuit comprises a ROM, RAM or SRAM memory and that said circuit part or parts (1) is/are a cell or a group or groups (1) of cells of said memory.

6. Circuit according to claim 5, **characterised in that** a group (1) of cells extends over at least one part (r₁ to rₙ) of the rows of a plurality of rows (<r₁, r₁ to rₙ, >rₙ) of the network of said memory and at least one part (c₁ to cₘ) of the columns of a plurality of columns (<c₁, c₁ to cₘ, >cₘ) of the network of said memory.

7. Circuit according to claim 6, **characterised in that** a group (1) of cells extends over an entire row of the network of said memory.

8. Circuit according to any one of claims 6 and 7, **characterised in that** said switching devices (MNS-c₁ to MNS-cₘ) are provided by part of the columns (c₁ to cₘ) of said group (1) of cells, and that said control devices (GSL, SC, 14) are common to the whole of said group (1) of cells collectively controlling said switching devices (MNS-c₁ to MNS-cₘ).

9. Circuit according to any one of claims 6 to 8, **characterised in that** said control signal (GS) is generated from a bit of the row address applied to said memory.

10. Circuit according to any one of claims 5 to 9, **characterised in that** in the active mode of the group (1) of cells said control signal (GS) is generated before the control signal corresponding to this active read and/or write mode (SW, SW') appears in the cells of the group (1) of cells.
